# EUROPEAN PATENT APPLICATION

(11) **EP 1 681 734 A1**
(43) Date of publication of application: **19.07.2006**
(21) Application number: 05405027.3
(22) Date of filing: 18.01.2005
(51) Int. Cl.: H01L 51/40, H01L 27/00

(54) **Optoelectronic device and method for producing the same**

(71) Applicant: C.S.E.M. CENTRE SUISSE D'ELECTRONIQUE ET DE MICROTECHNIQUE SA, 2007 Neuchâtel (CH)
(72) Inventor: Kiy, Michael, 8404 Winterthur (CH)
(74) Representative: Schneider Feldmann AG Patent- und Markenanwälte

(57) **Abstract**

The optoelectronic device (1) comprises a stack of at least three layers (4, 3, 5) and a supporting structure (2) for supporting the stack (4, 3, 5). The supporting structure (2) is sieve-like. The inner of the three layers (4, 3, 5) is an optically active layer (3), and the outer two of the three layers (4, 3, 5) are electrode layers (4, 5) arranged on either side of the optically active layer (3). The optically active layer (3) comprises an electroluminescent polymer material. By means of a voltage applied to the electrode layers (4, 5), the electroluminescent layer (3) is stimulated to emit light (91). The through holes of the supporting structure (2) are filled by the stack of layers (4, 3, 5). The parameters of the layers (4, 3, 5) are well controllable in the through holes. It is easy to deposit the stack of layers (4, 3, 5) only on a predefined area.

## Description

### FIELD OF THE INVENTION

The present invention is in the field of light generation, light detection and/or photovoltaic conversion. In particular, it relates to an optoelectronic device and to a method for producing the same.

### BACKGROUND OF THE INVENTION

Thin-film light-emitting devices based on polymers have been described in various publications. A typical thin-film light-emitting polymer device is based on one electroluminescent layer and, optionally, hole injection/transport layers sandwiched together with the electroluminescent materials between two electrical contact layers (electrodes). At least one of the contacts is transparent for the light produced by the active layers in order to transmit it to the outside. The devices are usually based on a substrate with a first electrode layer and several active layers deposited on the first electrode layer. A second electrode layer on top defines the sandwich structure. Such a sandwich structure is disclosed in WO-90/13148. The latter WO publication also teaches that polymers can be used as active materials. Figure 1 of WO-90/13148 gives a few examples of typical materials employed from the prior art in polymer electronic devices.

In the paper "Solid-state light emitting devices based on the tris-chelated Ruthenium(II) complex 4.-high efficiency light-emitting devices based on derivates of the - 3 -tris (2,2'-bipyridyl) Ruthenium(II) (Ru(bpy)₃) complex", Journal of the American Chemical Society, 124, 4918, 2002, Rudmann et al. describe a highly efficient light-emitting device based on electrochemical cells. An example of a light-emitting electrochemical cell is a conjugated polymer blended with a solid electrolyte that provides mobile ions.

Thin-film solar cells based on polymer films are reviewed in "Organic solar cells: an overview" by Hoppe and Sariciftci, Journal of material research, Volume 19, Number 7, 2004. Solution-compatible thin-film deposition processes such as spin coating, ink-jet printing, or doctor-blade technique can deposit the polymers.

Film thicknesses in the range of 20-200 nm have to be achieved for a device operating at low voltages (2 - 20 volts). Usually glass plates or plastic foils are used as substrates.

The above-mentioned thin-film deposition processes have, however, some disadvantages. The resulting film is lying on a substrate. Free standing films cannot be produced with these methods. The spin-coating and the doctor-blade technique can coat large areas, typically the whole substrate. However, it is not possible to selectively coat a certain region or part of the substrate. If only a small area is finally needed, the films have to be removed from large areas of the substrate, thus causing a considerable waste of materials and production speed.

### SUMMARY OF THE INVENTION

It is therefore an object of this invention to provide an optoelectronic device and a method for producing the same that do not suffer from the disadvantages described above. In particular, it shall be possible to produce the device on a predefined area of a substrate and thus to avoid waste of materials. These and other problems are solved by the device and the method as defined in the independent claims. Advantageous embodiments of the invention are given in the dependent claims.

The invention is based on the idea to support the layer stack for emitting or receiving light by means of a supporting structure that has a plurality of through holes. The supporting structure may have the form of a sieve, a net, a fabric, a mesh, a grid or a perforated foil. The through holes are filled by the stack of layers. Especially in the through holes, the parameters of the layers such as their thicknesses are well controllable. Each through hole represents an individual frame for an individual stack of layers. Thus, by providing a two-dimensional matrix of regular through-holes, the stack of layers will have regular properties in each through-hole, independent of its location on the supporting structure. Moreover, with such supporting structures, it is easy to deposit the stack of layers only on a predefined area, rather than on the whole substrate.

The optoelectronic device according to the invention comprises a stack of at least three layers and a supporting structure for supporting the stack. The supporting structure is sieve-like, reticular, net-shaped or netted and is preferably a fabric, a perforated foil or the like. One inner of the at least three layers is an optically active layer, and two of the at least three layers are electrode layers arranged on either side of the optically active layer. The optically active layer comprises a light-emissive or a light-receptive material, and preferably a polymer material.

The inventive method for producing an optoelectronic device comprises the steps of providing a supporting structure and forming a stack of at least three layers on the supporting structure. The supporting structure is chosen to be sieve-like, reticular, net-shaped or netted and preferably a fabric, a perforated foil or the like. One inner of the at least three layers is an optically active layer, and two of the at least three layers are electrode layers arranged on either side of the optically active layer. The optically active layer is chosen to comprise a light-emissive or a light-receptive material, and preferably a polymer material. At least one layer of the stack is preferably formed by depositing a liquid on the supporting structure and solidification of the liquid to form the layer.

### BRIEF DESCRIPTION OF THE DRAWINGS

Embodiments of the invention are described in greater detail hereinafter relative to the attached schematic drawings.
- Figures 1-4: show various steps of the manufacturing method according to the invention (a) in a top view and (b) in a cross section.
- Figures 5 and 6: show cross sections of the optoelectronic device according to the invention, used for light generation and for photovoltaic conversion, respectively.
- Figure 7: shows examples of materials for the optically active layer in the optoelectronic device according to the invention.

### DESCRIPTION OF PREFERRED EMBODIMENTS

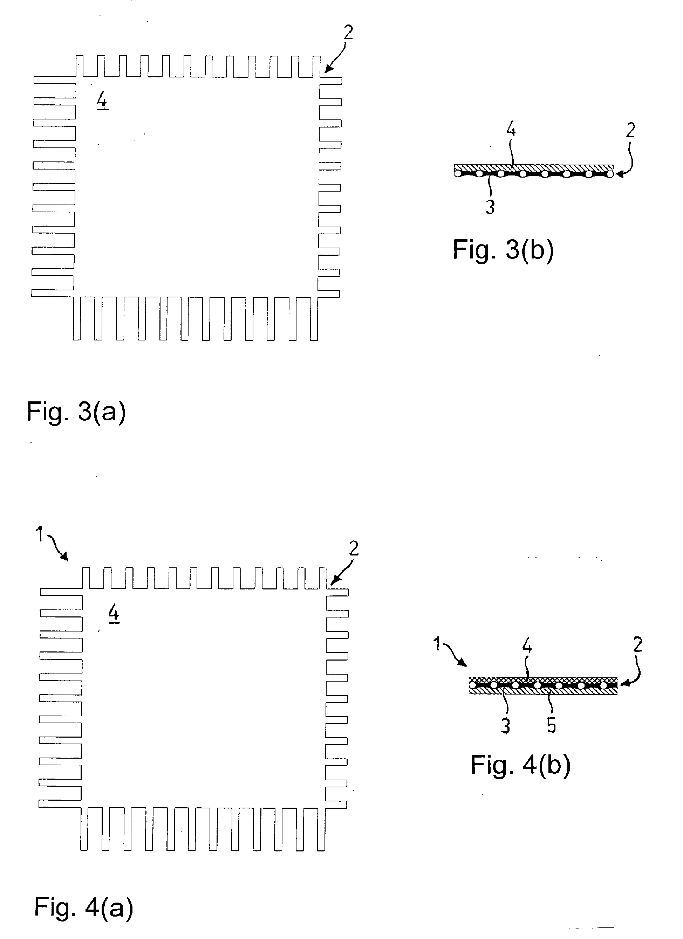

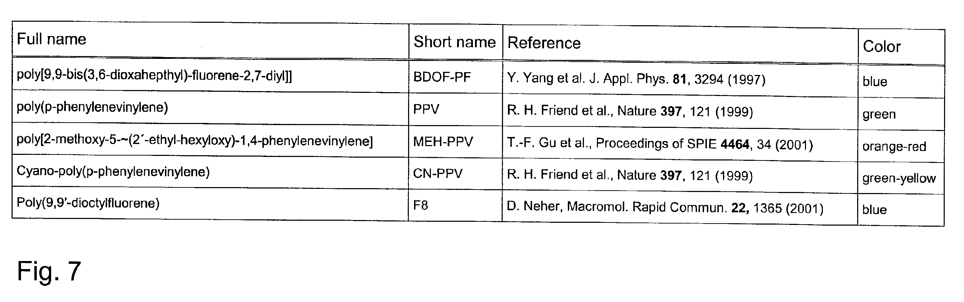

**Figure 4** shows an embodiment of the optoelectronic device 1 according to the invention. The device 1 comprises a sheet-like supporting structure 2 with a plurality of through holes 21, e.g., a fabric. The through holes 21 in the supporting structure 2 are filled with an electroluminescent polymer 3 such as Poly(9.9-dioctylfluorene) (F8). Further examples of materials suited for use as optically active material in the optoelectronic device 1 according to the invention are given in **Figure 7.** A first electrode layer 4 is formed on a first side of the supporting structure 2. The first electrode layer 4 may be formed from a conductive material such as a metal, a metal alloy, a conductive polymer, a conductive polymer and a metal, and/or a transparent conductive layer (such as indium tin oxide, ITO). A second electrode layer 5 is formed on a second side of the supporting structure 2. The second electrode layer 5 may be formed from a metal such as aluminum, a layered structure of metals such as barium/aluminum, calcium aluminum, a layered structure of metal and a thin dielectric layer, such as lithium fluoride/aluminum, a metal alloy such as silver:magnesium, a conductive polymer such as Polystyrene-sulphonic-acid-doped Poly(3,4-ethylenedioxythiophene) (PEDOT:PSS), or a transparent conductive layer (such as ITO). A hole injection layer and/or a hole transport layer can optionally be arranged between the optically active layer 3 and one of the electrode layers 4, 5. Of course, at least one of the electrode layers 4, 5 (and, where appropriate, the hole injection/transport layers) has to be at least partially transparent in the spectral bandwidth of the light that shall be emitted or received, in order to transmit the light to the outside or inside of the layer stack 4, 3, 5, respectively.

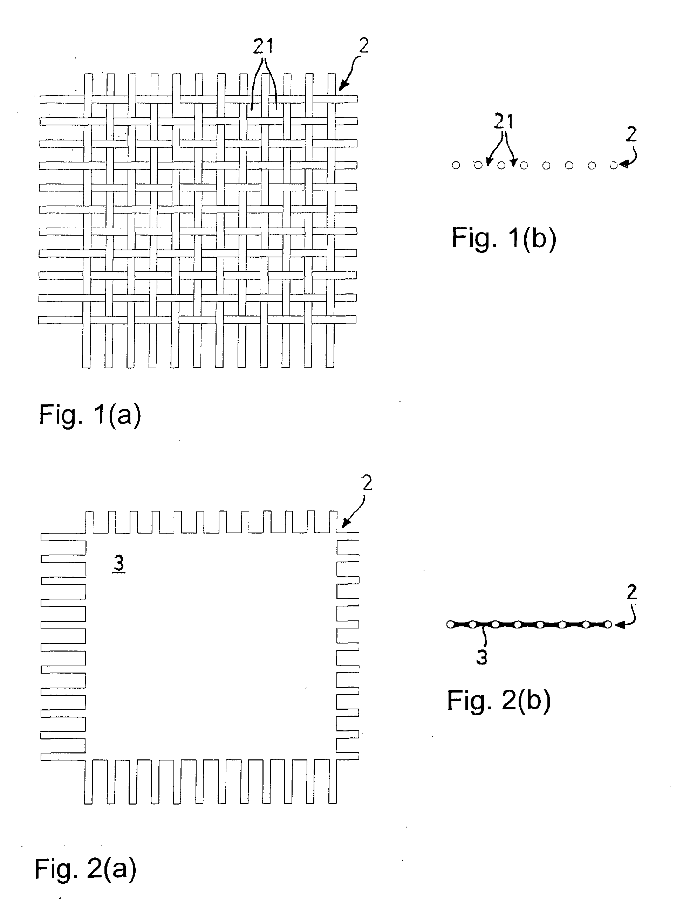

Various steps of an embodiment of the manufacturing method for the optoelectronic device 1 according to the invention are shown in **Figures 1-4.**

In a first step, a supporting structure 2 as shown in **Figure 1** is provided. The supporting structure 2 may be a sieve, a gauze, a fabric, a mesh, a foil with through holes 21 or any other sheet-like structure with through holes 21. In other words: the supporting structure 2 is sieve-like, reticular, net-shaped or netted. The supporting structure 2 may be made of cotton, plastic material such as polyester, glass, metal or other materials. In the embodiment shown in Fig. 1, a fabric woven of flexible longish elements such as fibers, wires, yarns, threads or stripes is used as supporting structure 2. In a preferred example, woven polyester threads with a diameter of 90 µm are used to form the supporting structure 2. Thus, the through holes 21 are arranged in a regular two-dimensional matrix. They may have a width between 1 µm and 1 mm, and preferably between 10 µm and 500 µm, e.g., 250 µm. The optimum hole width depends on the polymer used for the optically active layer 3 (see Fig. 2) and the concentration of the polymer in the solution.

In a second step shown in **Figure 2,** an optically active layer 3 comprising a light-emissive or a light-receptive material, preferably a polymer material, is formed on the supporting structure 2. This can be achieved by dipping the sieve-like supporting structure 2 into a polymer solution such as a PFO (70%) / N,N'-Di(3-methylphenyl)-N,N'-diphenyl-benzidin (TPD) (30%)- toluene solution. The liquid material is then solidified, e.g., by evaporating the toluene solvent. After drying, a very thin polymer layer 3 with a thickness between 50 and 500 nm remains. The polymer layer 3 fills the through holes 21 of the supporting structure 2, and may also cover the threads of which the supporting structure 2 is formed.

In a third step, an anode layer 4 is formed on one side of the supporting structure 2, as illustrated in **Figure 3.** This may be for instance achieved by covering one side of the supporting structure 2 by a thin PEDOT:PSS film and heating at 120 °C for 30 minutes to dry the PEDOT:PSS layer. The thickness of the layer can range from 30 to 300 nm. It may be advantageous to deposit in a vacuum deposition chamber a 10 nm thin film of silver onto the PEDOT:PSS film to reduce the resistivity of the PEDOT:PSS electrode layer 4.

Finally, a cathode layer 5 is deposited on the other side of the supporting structure 2, as shown in **Figure 4.** The cathode layer 5 may be a combination of barium and aluminum film, e.g., barium 5 nm and aluminum 100 nm thick.

The optoelectronic device 1 according to the invention can be used for light generation, light detection and/or photovoltaic conversion.

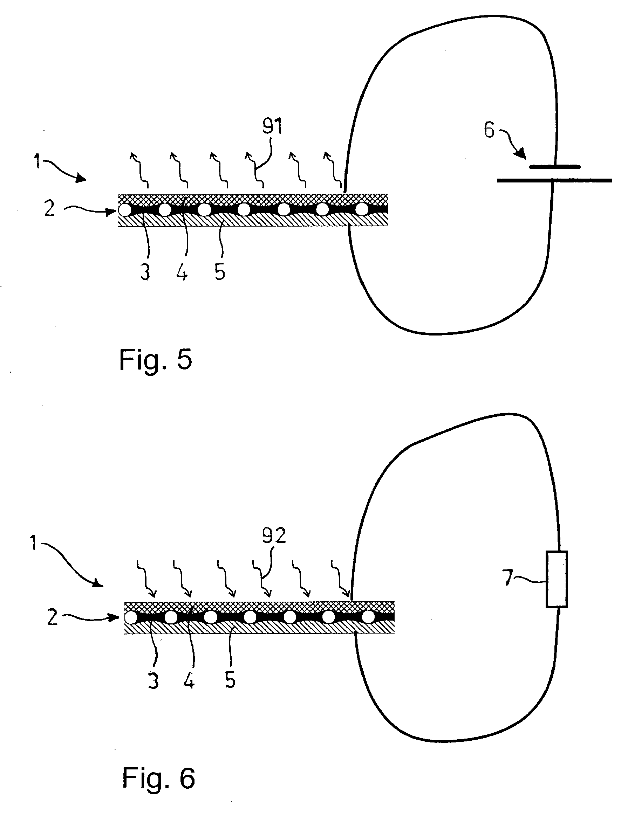

**Figure 5** shows the operation of the optoelectronic device 1 according to the invention as a light-emitting device. The optically active layer 3 is in this case an electroluminescent layer. A voltage-generating means 6 is provided for applying a voltage to the electrode layers 4, 5 on both sides on the electroluminescent layer 3: a positive pole to the anode side and a negative pole to the cathode side. Light 91 generated in the electroluminescent layer 3 is emitted to the outside through the PEDOT:PSS film and the thin silver contact which form together the anode layer 4. The light-emitting device 1 can be patterned to emit predefined light patterns, e.g., for information or decoration purposes. Appropriate patterning techniques are known from the related art for polymer light-emitting devices, e.g., from taught by U.S. Patent No. 5,902,688 or WO2004/068584.

The optoelectronic device 1 according to the invention can be used as light-sensitive or solar-cell device as well. A polymer layer 3 optimized for light absorption can then replace the electroluminescent layer of Fig. 5. The operation of such an optoelectronic device 1 is shown in **Figure 6.** Incident light 92 is converted into electricity, and the resulting voltage on the electrode layers 4, 5 on both sides on the optically active layer 3 can be used to drive a consumer 7 (depicted as resistance in Figure 6).

This invention is not limited to the preferred embodiments described above, to which variations and improvements may be made, without departing from the scope of protection of the present patent.

### LIST OF REFERENCE SIGNS

- 1: Optoelectronic device

- 2: Supporting structure
- 21: Through holes

- 3: Optically active layer
- 4: Anode layer
- 5: Cathode layer
- 6: Voltage-generating means
- 7: Consumer

- 91: Incident light
- 92: Emitted light

## Claims

1. An optoelectronic device (1) comprising
a stack of at least three layers (4, 3, 5), one inner of the at least three layers (4, 3, 5) being an optically active layer (3) and
two of the at least three layers (4, 3, 5) being electrode layers (4, 5) arranged on either side of the optically active layer (3), and
a supporting structure (2) for supporting the stack (4, 3, 5),
**characterized in that**
the supporting structure (2) is sieve-like.

2. The optoelectronic device (1) according to claim 1, wherein the supporting structure (2) is a sieve, a net, a fabric, a mesh, a grid or a perforated foil, and is preferably made of a material selected from the group consisting of cotton, plastic material such as polyester, glass, and metal.

3. The optoelectronic device (1) according to any of the preceding claims, wherein the supporting structure (2) has through holes (21) with a width between 1 µm and 1 mm, and preferably between 10 µm and 500 µm.

4. The optoelectronic device (1) according to any of the preceding claims, wherein the supporting structure (2) has through holes (21) arranged in a regular two-dimensional matrix.

5. The optoelectronic device (1) according to any of the preceding claims, wherein the supporting structure (2) has through holes (21) that are filled with the stack (4, 3, 5).

6. The optoelectronic device (1) according to any of the preceding claims, wherein the optically active layer (3) comprises a light-emissive or a light-receptive material, and preferably a polymer material, e.g., an electroluminescent polymer such as BDOF-PF, PPV, MEH-PPV, CN-PPV or F8.

7. The optoelectronic device (1) according to any of the preceding claims, wherein at least one of the electrode layers (4, 5) comprises a material selected from the group consisting of metal such as aluminum, barium and/or calcium, metal alloy such as silver:magnesium, conductive polymer such as Poly(3,4-ethylenedioxythiophene) doped with Polystyrene sulphonic acid, and transparent conductive material such as indium tin oxide, or a combination of the aforementioned materials.

8. The optoelectronic device (1) according to any of the preceding claims, wherein a hole injection layer and/or a hole transport layer is arranged between the optically active layer (3) and one of the electrode layers (4, 5).

9. Use of the optoelectronic device (1) according to any of the preceding claims for light generation, light detection and/or photovoltaic conversion.

10. A method for producing an optoelectronic device (1), comprising the steps of:
providing a supporting structure (2), and
forming a stack of at least three layers (4, 3, 5) on the supporting structure (2), such that
one inner of the at least three layers (4, 3, 5) is an optically active layer (3) and
two of the at least three layers (4, 3, 5) are electrode layers (4, 5) arranged on either side of the optically active layer (3), and
**characterized in that**
the supporting structure (2) is chosen to be sieve-like.

11. The method according to claim 10, wherein the supporting structure (2) is chosen to be a sieve, a net, a fabric, a mesh, a grid or a perforated foil, and is preferably made of a material selected from the group consisting of cotton, plastic material such as polyester, glass, and metal.

12. The method according to claim 10 or 11, wherein the optically active layer (3) is chosen to comprise a light-emissive or a light-receptive material, and preferably a polymer material, e.g., an electroluminescent polymer such as Poly(9.9-dioctylfluorene).

13. The method according to any of the claims 10-12, wherein at least one of the electrode layers (4, 5) is chosen to comprise a material selected from the group consisting of metal such as aluminum, barium and/or calcium, metal alloy such as silver:magnesium, conductive polymer such as Poly(3,4-ethylenedioxythiophene) doped with Polystyrene sulphonic acid, and transparent conductive material such as indium tin oxide, or a combination of the aforementioned materials.

14. The method according to any of the claims 10-13, wherein at least one layer (3) of the stack (4, 3, 5) is formed by depositing a liquid on the supporting structure (2) and solidificating the liquid to form the layer (3).

15. The method according to claim 14, wherein the liquid deposition comprises dip-coating.
